# EUROPÄISCHE PATENTSCHRIFT

(11) **EP 2 237 057 B1**
(45) Veröffentlichungstag und Bekanntmachung des Hinweises auf die Patenterteilung: **21.02.2018**
(21) Anmeldenummer: 09004983.4
(22) Anmeldetag: 03.04.2009
(51) Int. Cl.: G01R 31/02, G01R 27/18, H02J 4/00

(54) **Analysevorrichtung zur Analyse eines Stromnetzes**
Analysis device for analysing an electricity network
Dispositif d'analyse destiné à l'analyse d'un réseau électrique

(43) Veröffentlichungstag der Anmeldung: 06.10.2010
(73) Patentinhaber: Siemens Aktiengesellschaft, 80333 München (DE)
(72) Erfinder: Dausend, Stefan, 91126 Schwabach (DE); Maier, Martin, 73760 Ostfildern (DE); Schaan, Stefan, 90592 Schwarzenbruck-Pfeifferhütte (DE)

(56) Entgegenhaltungen:
- EP-A- 1 265 076
- EP-A- 1 950 575
- EP-A2- 0 593 007
- EP-A2- 1 820 034
- AT-B- 397 728
- DE-A1- 3 112 952
- US-A- 5 514 964
- US-A- 5 990 685
- US-A1- 2004 227 521
- US-A1- 2005 280 422

## Beschreibung

Die vorliegende Erfindung betrifft eine Analysevorrichtung zur Analyse eines Stromnetzes, insbesondere zur Erdschluss-Analyse eines Stromnetzes, umfassend:
- Ein erstes Anschlusselement zum Herstellen einer elektrischen Verbindung der Analysevorrichtung mit einem Leitungselement eines Stromnetzes, insbesondere mit einem Anschlusspunkt des Stromnetzes im Bereich einer Spannungsversorgung für das Stromnetz,
- ein zweites Anschlusselement zum Herstellen einer elektrischen Verbindung der Analysevorrichtung mit einem Erdpotential,
- eine Strommesseinrichtung zur Messung eines Stroms durch die Analysevorrichtung zwischen erstem und zweitem Anschlusselement.

Derartige Analysevorrichtungen sind aus dem Stand der Technik bekannt. So offenbaren beispielsweise die Patentschriften EP 0 593 007 B1, DE 31 12 952 C2 US 5990685 A, US 2004/0227521 A, US-2005/0280422 A oder US-5514964 A jeweils Vorrichtungen zur Bestimmung der Netzableitung von erdfreien Netzen mit Hilfe der Messung entsprechender Ströme zwischen dem Stromnetz und dem Erdpotential.

Der genannte Stand der Technik hat den Nachteil, dass die Fehlersuche in entsprechenden Stromnetzen eine hohe Fachkenntnis und hohes Detailwissen über das entsprechende Stromnetz erfordert, um mit Hilfe der genannten Vorrichtungen die Netzableitung beziehungsweise Erdfehler eines solchen Netzes zu ermitteln.

Daher ist es eine Aufgabe der vorliegenden Erfindung, eine einfachere Analysemöglichkeit für Stromnetze gegenüber Erdschlüssen und/oder Erdfehlern zu ermöglichen.

Diese Aufgabe wird gelöst durch ein Analysesystem, umfassend eine Analysevorrichtung und eine Automatisierungsvorrichtung, gemäß Anspruch 1. Durch die in der Analysevorrichtung vorhandene Feldbus-Schnittstelle wird es möglich, in der Analysevorrichtung gemessene Strom-Messwerte, deren Größe ein Maß oder Indiz für die Stärke der Netzableitung eines erdfreien Netzes sein kann, weiter zu verarbeiten. Eine solche Weiterverarbeitung kann beispielsweise in der Übertragung eines Messwerts zu einem Bediener, beispielsweise mit einem mobilen Empfangselement, oder auch die automatisierte Weiterverarbeitung eines solchen Messwerts sein. Auf diese Weise kann beispielsweise ein Bediener bei einem ausgedehnteren Netz einfacher die gemessenen Stromwerte überwachen und so fehlerhafte Stellen im Stromnetz finden, beispielsweise durch An- und Abschalten von Verbrauchern oder Verbindungen und parallelem Beobachten der Stromwerte.

Eine weitere Verarbeitung kann beispielsweise auch automatisiert bzw. zumindest teilweise automatisiert erfolgen. Durch eine solche automatisierte Weiterverarbeitung kann z.B. auch ohne einen Bediener eine entsprechende Netzsteuerung, wie beispielsweise ein Abschalten bei entsprechenden Erdfehlern, vorgenommen werden, bevor es zu Schäden an Geräten oder auch Personen kommen kann.

Stromnetz können dabei zum Beispiel einfache oder auch verzweigte Stromkreise oder aber auch kleinere, mittlere und große Stromnetze sein.

Die ersten und zweiten Anschlusselemente können beliebige Arten von Steckern, Buchsen, Klemmkontaktelementen, Berühr-Kontakte oder -Kontakt-Pads, Lötpads, Lötstellen, Lötpunkte, Klebeflächen oder Ähnliches sein.

Das Leitungselement, mit welchem das erste Anschlusselement der Analysevorrichtung verbindbar oder verbunden ist, kann beispielsweise ein auf einem Nullpotential liegendes Leitungselement sein (z.B. ein Null-Leiter).

Ein Anschlusspunkt des ersten Anschlusselements am Stromnetz kann beispielsweise am oder in der Nähe eines Anschlusses einer Spannungsversorgung für das Stromnetz für einen solchen Null-Potential-Anschluss beziehungsweise Null-Leiter sein. Ein solcher Anschlusspunkt kann aber auch an beliebigen Stellen des Stromnetzes gewählt sein. Das Stromnetz kann beispielsweise ein erdfreies Stromnetz sein oder eine Punkterdung aufweisen. Die Punkterdung kann beispielsweise als eine Ein-Punkt-Erdung, eine Mehr-Punkt-Erdung oder auch eine Stern-Punkt-Erdung ausbildet sein. Weiterhin kann die Punkt-Erdung unter Verwendung der Analysevorrichtung vorgenommen sein bzw. die Analysevorrichtung kann Bestandteil der Punkterdung für das Stromnetz sein.

Die Analysevorrichtung kann beispielsweise in der Nähe einer Spannungsversorgung für das Stromnetz, z.B. in einem Schaltschrank, angebracht sein. Es ist aber auch eine Verwendung einer solchen Analysevorrichtung außerhalb von Schaltschränken möglich. Zur Vermeidung von Schäden an der Analysevorrichtung kann diese beispielsweise gemäß der Schutzart IP20 oder IP67 ausgebildet sein, um die Analyse von Stromnetzen auch in raueren Umgebungen zu ermöglichen.

Die Strommesseinrichtung kann beispielsweise einen niederohmigen, so genannten "Shunt"-Widerstand umfassen, wobei mit Hilfe eines Spannungsmessers die über den Shunt abfallende Spannung bei dem durch die Analysevorrichtung fließenden Strom gemessen wird. Dieser in der Strommesseinrichtung gemessene Wert wird innerhalb der vorliegenden Beschreibung als der Strommesswert der Analysevorrichtung bezeichnet.

Unter einem Feldbus wird innerhalb der vorliegenden Beschreibung ein Feldbus im weiteren Sinne zum Kontaktieren von beispielsweise Aktoren oder Sensoren mit einem Kontroll- oder Automatisierungssystem verstanden. Solche Feldbusse können beispielsweise als Punkt-zu-Punkt-Verbindung ausgestaltet sein, die wiederum unidirektional oder auch bidirektional ausgestaltet sein kann. Bevorzugt kann ein bidirektionaler Feldbus verwendet werden, da dadurch sowohl die Ausgabe von Messerwerten von der Analysevorrichtung als auch die Eingabe von Steuerbefehlen in die Analysevorrichtung über den Feldbus möglich ist.

Eine Feldbusverbindung kann beispielsweise gemäß dem "I/O-Link"-Standard, dem "AS-i"-Standard, dem "Profibus DP"-Standard oder auch dem "Profinet-IO"-Standard ausgestaltet sein. Vorzugsweise kann ein relativ einfacher Feldbus mit vier oder weniger Anschlussleitungen, insbesondere mit zwei oder drei Anschlussleitungen, verwendet werden. Solche relativ einfachen Feldbusse können beispielsweise gemäß dem "I/O-Link"-Standard oder dem "AS-i"-Standard ausgebildet sein. Durch die Verwendung einer solchen relativ einfachen Feldbus-Schnittstelle lässt sich der Hardware- und/oder Software-Aufwand für eine solche Schnittstelle in einem relativ geringen Rahmen halten, was relativ kleine und preiswerte Analysevorrichtungen ermöglicht.

Eine Analysevorrichtung kann neben der Feldbus-Schnittstelle auch weiterhin ein Anzeigeelement aufweisen, mit welchem sich gemessene Strommesswerte darstellen lassen oder Strommesswert-Bereiche darstellen lassen. Strommesswerte können beispielsweise über eine digitale oder analoge Anzeige angezeigt werden. Strommesswert-Bereiche können beispielsweise durch Signalelemente (verschiedene LEDs oder Leuchten, eine oder mehrere LEDs oder Leuchten mit Farbcodierungen, ...) angezeigt werden, wobei beispielsweise ein erstes Signalelement für einen unkritischen Strommesswert-Bereich und ein zweites Signalelement für einen kritischen Strommesswert-Bereich vorgesehen sein kann. Gegebenenfalls kann z.B. auch noch ein weiteres Signalelement für einen zwar beachtenswerten aber noch nicht gefährlichen Strommesswert-Bereich vorgesehen sein. Dieser Grundgedanke ist auf beliebige Ausgestaltungen und Anzahlen von einem oder mehreren derartiger Anzeigeelemente anwendbar. Die Analysevorrichtung umfasst weiterhin eine Trenneinrichtung, wobei in einem Verbindungszustand der Trenneinrichtung eine durchgehende, insbesondere niederohmige (z.B. kleiner als 1 Kilo-Ohm oder vorzugsweise kleiner als 1 Ohm oder weiter bevorzugt kleiner als 0,01 Ohm), elektrische Verbindung zwischen dem ersten und zweiten Anschlusselement innerhalb der Analysevorrichtung besteht, und in einem Trennzustand der Trenneinrichtung eine Unterbrechung der durchgehenden elektrischen Verbindung zwischen dem ersten und zweiten Anschlusselement innerhalb der Analysevorrichtung vorliegt oder die durchgehende elektrische Verbindung hochohmig ist.

Eine solche Trenneinrichtung ermöglicht z.B. einen Notbetrieb einer elektrischen Schaltung bei vorliegenden Erdschlussfehlern, indem die über die Erde abfließenden Ströme durch eine Unterbrechung der Verbindung in der Analysevorrichtung zumindest reduziert werden können. Auf diese Weise kann insbesondere in Anlagen oder Stromkreisen, bei welchen eine Abschaltung zu größeren Schäden, Gefahren oder Kosten führen würde, zumindest für einige Zeit der Betrieb weiter aufrecht erhalten werden, bis entweder eine mögliche Stillstandszeit zur Fehlersuche festgelegt werden kann, oder während des Notbetriebs sogar der Fehler gesucht und gefunden werden kann.

Eine Trenneinrichtung kann beispielsweise als Schalter zum Öffnen und Schließen einer stromführenden Verbindung ausgebildet sein. Eine Trenneinrichtung, bei welcher im Trennzustand eine sehr hochohmige Verbindung vorliegt, kann beispielsweise durch Zuschalten eines hohen Widerstands realisiert sein. Ein solcher hoher Widerstand kann beispielsweise einen Widerstandswert von 1 Kilo-Ohm oder mehr aufweisen, bevorzugt 100 Kilo-Ohm oder mehr aufweisen, weiter bevorzugt 1 Mega-Ohm oder mehr aufweisen, oder mehr aufweisen.

Die Analysevorrichtung kann weiterhin ein Bedienelement zum manuellen Umschalten der Trenneinrichtung vom Verbindungszustand in den Trennzustand und/oder umgekehrt umfassen. Mit Hilfe eines solchen Bedienelements, beispielsweise einem oder mehreren an der Analysevorrichtung angebrachten Schaltern, Tastern oder Touchscreens, kann ein Bediener dann beispielsweise in einem Fehlerfall die Trenneinrichtung bedienen, um einen Trennzustand herzustellen oder nach erfolgter Reparatur den normalen Verbindungszustand wieder herstellen. Dies ermöglicht wiederum eine einfachere Analysemöglichkeit für die Bestimmung von Erdfehlern eines Stromnetzes, indem mittels eines solchen Notbetriebs eine Fehleranalyse zumindest zweitweise auch während des Betriebs des Stromnetzes möglich ist.

Die Feldbus-Schnittstelle und die Analysevorrichtung sind derart ausgebildet und eingerichtet, dass durch einen über einen Feldbus in der Feldbus-Schnittstelle eingehenden Steuerbefehl die Trenneinrichtung vom Verbindungszustand in den Trennzustand bringbar ist bzw. gebracht wird und/oder umgekehrt. Auf diese Weise lässt sich über den Feldbus und die Feldbus-Schnittstelle die genannte Trenneinrichtung quasi "fernsteuern". So kann die Trenneinrichtung beispielsweise von einem Bediener an einem entfernt der Analysevorrichtung befindlichen Bedienelement, beispielsweise an einem tragbaren Bedienelement, betätigt werden.

Weiterhin kann auch eine automatische Bedienung der Trenneinrichtung durch eine Steuereinheit über den Feldbus erfolgen. Dies vereinfacht wiederum die Analyse des Stromnetzes, da der Bediener so unabhängiger von der Analysevorrichtung auf Fehlersuche gehen kann. Weiterhin kann auf diese Weise auch zumindest eine Teilanalyse automatisiert oder eine Analyse mit automatischer Unterstützung durchgeführt werden.

Beispielsweise zur Verbesserung der Analysemöglichkeiten im oben genannten Notbetrieb, kann die Analysevorrichtung weiterhin eine Spannungsmesseinrichtung zur Messung und Ausgabe einer über die Trenneinrichtung abfallenden Spannung umfassen. Dabei kann z.B. die Feldbus-Schnittstelle zur Ausgabe eines von der Spannungsmesseinrichtung ermittelten Messwerts über den Feldbus eingerichtet und ausgebildet sein. Insbesondere bei im Trennzustand befindlicher Trenneinrichtung kann die über die Trenneinrichtung, beispielsweise einem geöffneten Schalter, abfallende Spannung bei der Analyse von Fehlern innerhalb eines zu beobachtenden Stromkreises hilfreich sein. So kann beispielsweise die Veränderung dieser Spannung beim Ein- und Ausschalten von Geräten im Stromkreis oder auch Öffnen und Schließen von Verbindungen im Stromkreis ein weiterer Hinweis auf vorliegenden Fehlerquellen im Stromnetz sein. Diese Analyse lässt sich auch im vorstehend genannten Notbetrieb durchführen. Auf diese Weise ergibt sich eine weiterhin verbesserte Analysemöglichkeit für ein Stromnetz.

Im Rahmen der vorliegenden Beschreibung wird unter einem Spannungsmesswert dieser über die Trenneinrichtung abfallende Spannungswert verstanden, im Gegensatz zum vorsehend genannten Strommesswert, der mittels der Strommesseinrichtung ermittelt wird oder ermittelbar ist. In einem Beispiel kann ein Erdungssystem für ein Stromnetz eine Analysevorrichtung gemäß der vorliegenden Beschreibung umfassen, wobei das erste Anschlusselement der Analysevorrichtung elektrisch mit einem Leitungselement des Stromnetzes, insbesondere mit einem Anschlusspunkt des Stromnetzes im Bereich einer Spannungsversorgung für das Stromnetz, verbunden ist, und das zweite Anschlusselement mit einem Erdpotential verbunden ist, wobei insbesondere weiterhin das Punkterdungssystem als eine Punkterdung für das Stromnetz ausgebildet ist. Das Leitungselement des Stromnetzes, an welches das erste Anschlusselement angeschlossen ist, der Anschlusspunkt des Stromnetzes im Bereich einer Spannungsversorgung sowie die Erdung bzw. Punkterdung, können dabei gemäß der vorliegenden Beschreibung ausgebildet sein. Das Analysesystem für ein Stromnetz umfasst:
- Eine Analysevorrichtung gemäß der vorliegenden Beschreibung oder ein Erdungssystem gemäß der vorliegenden Beschreibung, sowie
- eine Automatisierungseinrichtung, wobei die Automatisierungseinrichtung über eine Feldbus-Leitung mit der Feldbus-Schnittstelle der Analysevorrichtung verbunden ist oder verbindbar ist.

Mit einem solchen Analysesystem lässt sich die Analyse von Stromnetzen, beispielsweise auf Erdfehler oder Netzableitungen, weiter vereinfachen, da mittels der Automatisierungseinrichtung die von der Analysevorrichtung kommenden Daten weiter verarbeitet und dargestellt werden können. Weiterhin können Steuerungsbefehle an die Analysevorrichtung gegeben werden und auch weitere Steuerungsbefehle an Elemente, Teile oder auch das gesamte Stromnetz gegeben werden können um z.B. auf bestimmte Messwerte der Analysevorrichtung zur reagieren. Die Merkmale und Elemente des genannten Analysesystems können dabei gemäß der vorliegenden Beschreibung ausgestaltet und eingerichtet sein.

Zur einfacheren Bedienung durch einen Benutzer kann die Automatisierungseinrichtung beispielsweise eine Bedieneinheit, insbesondere eine tragbare Bedieneinheit, zur Anzeige von in der Analysevorrichtung ermittelten Strom- und/oder Spannungsmesswerten beziehungsweise Strom und/oder Spannungsmesswert-Bereichen aufweisen. Mittels einer solchen Bedieneinheit ist ein Benutzer bei der Analyse des Stromnetzes dann nicht mehr an den Standort der Analysevorrichtung gebunden, sondern kann beispielsweise an Stellen die entsprechenden Messwerte betrachten, an welchen er direkt eine Fehlerbearbeitung am Stromnetz durchführt oder durchführen kann.

Die tragbare Bedieneinheit kann beispielsweise als eine einfach mittels ein und/oder zwei Händen tragbare Bedieneinheit ausgebildet sein, die im Rahmen eines normalen Arbeitsablaufs mit einem Bediener mitgeführt werden kann. Die Anzeigeeinrichtung zur Darstellung der genannten Messwerte oder Messwertbereiche kann dabei, wie in der vorliegenden Beschreibung bereits an anderer Stelle näher erläutert, ausgebildet sein.

Weiterhin kann die Bedieneinheit oder die tragbare Bedieneinheit zur Eingabe von Steuerbefehlen zum Umschalten der Trenneinrichtung vom Verbindungszustand in den Trennzustand, und/oder umgekehrt, ausgebildet und eingerichtet sein. Auf diese Weise lässt sich mittels der Bedieneinheit von einem der Analysevorrichtung fernliegenden Ort die Trenneinrichtung quasi fernsteuern, was die Analyse der Stromnetze weiter vereinfacht. Die Bedienung kann dabei beispielsweise über entsprechende Schalter, Taster oder ein oder mehrere Touch-Pannels erfolgen.

Die Automatisierungseinrichtung ist dabei weiterhin derart ausgestaltet und eingerichtet, dass die Trenneinrichtung über die Feldbus-Schnittstelle selbsttätig vom Verbindungszustand in den Trennzustand gebracht wird, wenn ein in der Analyseeinrichtung ermittelter Strommesswert einen festen, vorgegebenen oder vorgebbaren Grenzwert übersteigt. Auf diese Weise lässt sich beispielsweise ein Einschalten eines Notbetriebs realisieren, mittels welchem bei Erreichen eines kritischen Zustands, der durch den entsprechenden Grenzwert festgelegt ist, einen Notbetrieb des Stromnetzes möglich wird. Damit können beispielsweise Schäden an Geräten und/oder Personen oder sonstige Gefahren vermieden werden. Weiterhin kann in diesem Falle beispielsweise eine entsprechende Warnmeldung ausgegeben werden und/oder der Notbetrieb auch zeitlich begrenzt werden.

Weiterhin kann die Automatisierungseinrichtung auch derart ausgestaltet und eingerichtet sein, dass, wenn der Strommesswert einen weiteren Grenzwert erreicht (der z.B. unterhalb des o.g. Grenzwerts liegen kann), nur ein Warnsignal an einen Benutzer ausgegeben wird. Dieses Warnsignal kann dem Benutzer dann beispielsweise signalisieren, dass das Stromnetz zwar noch nicht in einem kritischen Zustand befindlich ist, allerdings ein solcher möglicherweise bevorstehen könnte beziehungsweise trotzdem eine Fehlersuche initiiert werden sollte.

Weiterhin kann die Automatisierungseinrichtung auch eine zeitliche Abfolge von Strom und/oder Spannungsmesswerten erfassen, Speichern und/oder Auswerten, so dass auf Grund der zeitlichen Abfolge der Messwerte die Ausgabe von Zustandssignalen an einen Bediener bezüglich des Zustands des Stromnetzes ermöglicht wird. Auf diese Weise kann ein Bediener eines Stromnetzes auf einen eventuell bevorstehenden Ausfall des Stromnetzes frühzeitig hingewiesen werden. Diese Ausgestaltungen und Einrichtung der Automatisierungseinrichtung ermöglichen ebenfalls eine vereinfachte Analyse von Stromnetzwerken. In einem Beispiel umfasst einer Spannungsquelle zur Versorgung eines Stromnetzes mit elektrischer Energie:
- ein Gehäuse,
- eine Spannungs- und/oder Stromversorgungseinrichtung innerhalb des Gehäuses,
- eine Analysevorrichtung gemäß der vorliegenden Beschreibung innerhalb des Gehäuses,
wobei das Gehäuse weiterhin aufweist:
- mindestens zwei mit der Spannungs- und/oder Stromversorgungseinrichtung verbundene Kontaktelemente zum Anschluss eines Stromnetzes,
- einen Erdungsanschluss zur Erdung der Spannungsquelle, insbesondere zur Punkterdung eines an die Spannungsquelle angeschlossenen Stromnetzes, wobei der Erdungsanschluss im Gehäuse mit dem zweiten Anschlusselement der Analysevorrichtung elektrisch verbunden ist, und
- einen Feldbus-Aschluss zum Anschluss einer Feldbusleitung, wobei der Feldbus-Anschluss im Gehäuse mit der Feldbus-Schnittstelle der Analysevorrichtung elektrisch verbunden ist.

Mittels einer solchen Spannungsquelle, welche z.B. als Kombination einer herkömmlichen Spannungsquelle mit einer Analysevorrichtung gemäß der vorliegenden Beschreibung aufgefasst werden kann, lassen sich die Analysemöglichkeiten der genannten Analysevorrichtung nützen, ohne diese erst extra mit der Spannungsquelle beziehungsweise dem Stromnetz verdrahten zu müssen. Dies kann beispielsweise bei transportablen Spannungsquellen oder auch nur temporär aufgebauten Stromnetzen eine erhebliche Vereinfachung zur Analyse der jeweiligen Stromnetze darstellen.

Dabei kann beispielsweise der Erdungsanschluss am Gehäuse auch eine bauliche Einheit zu einem der Kontaktelemente zum Anschluss des Stromnetzes am Gehäuse darstellen.

Weiterhin kann die Spannungsquelle eine Anzeigeeinrichtung zur Darstellung von durch die Analysevorrichtung gemessenen Stromwerten und/oder Spannungswerten beziehungsweise Strommesswert-Bereichen und/oder Spannungsmesswert-Bereichen aufweisen. Eine solche Anzeigeeinrichtung kann beispielsweise, wie in der vorliegenden Beschreibung an anderen Stellen bereits beschrieben, ausgestaltet sein.

Weitere vorteilhafte Ausgestaltungen der Erfindung finden sich in den Unteransprüchen.

Im Folgenden wird die Erfindung beispielhaft mit Bezug auf die beiliegenden Figuren näher erläutert.

Es zeigen:
Figur 1: Außenansicht eines Beispiels für eine Analysevorrichtung;
Figur 2: Beispiel für ein Stromnetz mit angeschlossener Analysevorrichtung und Automatisierungseinrichtung;
Figur 3: Detaildarstellung eines Beispiels für ein Trennelement gemäß Figur 2;
Figur 4: Detaildarstellung eines Beispiels für eine Strommesseinrichtung gemäß Figur 2.

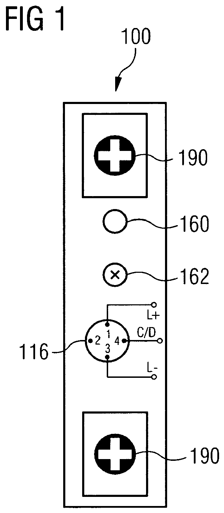

Figur 1 zeigt die Vorderansicht eines Erdschluss-Analysegeräts 100, welches ein Beispiel für eine Analysevorrichtung gemäß der vorliegenden Beschreibung ist. Das Erdschluss-Analysegerät 100 weist an seiner Vorderseite einen I/O-Link-Anschluss 116 auf, der ein Beispiel für einen Feldbus-Anschluss gemäß der vorliegenden Beschreibung darstellt. Weiterhin weist das Erdschluss-Analysegerät 100 eine Warnleuchte 160 auf, welche in Betrieb geht, sobald ein vom Erdschuss-Analysegerät 100 gemessener Strom einen vorgegebenen Grenzwert übersteigt. Weiterhin ist eine Normalzustands-Leuchte 162 vorgesehen, welche bei Normalbetrieb beziehungsweise beispielsweise ordnungsgemäßem Betrieb des Erdschluss-Analysegeräts 100 in Betrieb ist. Mittels zweier Kreuzschlitzschrauben 190 ist das Erdschluss-Analysegerät 100 beispielsweise an einer Halterung befestigbar.

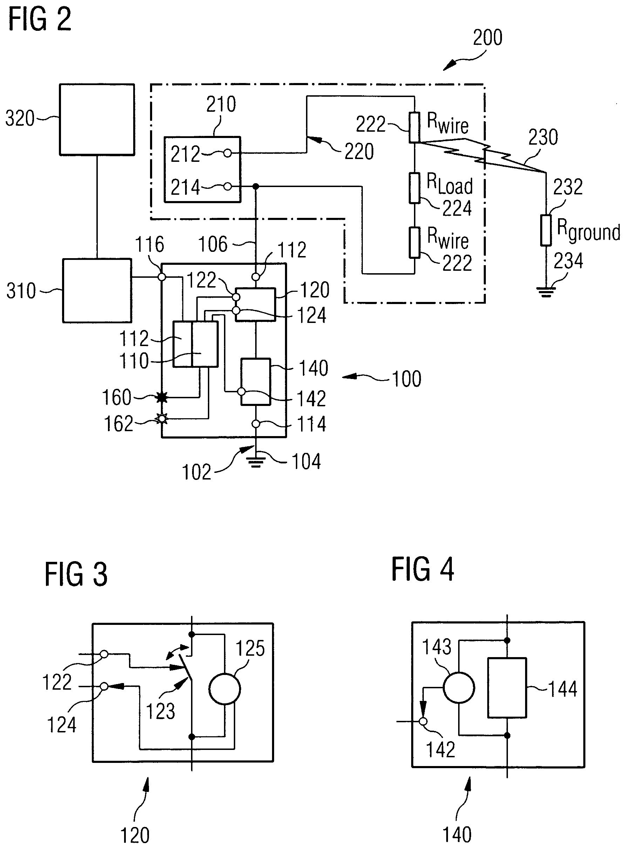

Figur 2 zeigt den Aufbau des in Figur 1 dargestellten Erdschluss-Analysegeräts 100 nach einem Anschluss an ein Stromnetz 200. Das Stromnetz 200 umfasst eine Spannungsquelle 210 mit einem 24 Volt Ausgang 212 und einem Null Potential Ausgang 214, wobei das Stromnetz aus einem einfachen Leiterkreis 220 besteht. Die im Stromnetz vorliegenden Widerstände sind durch Drahtwiderstände 222 und einen Lastwiderstand 224 symbolisiert. Ein Blitz-Zeichen 230 symbolisiert unbeabsichtigt Ableitung des Leiterkreises 220 über einen Kurzschlusswiderstand 232 an einen Erdungspunkt 234 mit Erdpotential. An die Stromleitung 220 des Stromnetzes 200 ist im Bereich des Null Potential Anschlusses 214 eine Anschlussleitung 106 zur Verbindung mit dem Erdschluss-Analysegerät 100 vorgesehen.

Das Erdschluss-Analysegerät 100 ist über einen Netzanschluss 112 und die Zuleitung 106 mit dem Stromkreis 220 und über einen Erdkontakt 114 und eine Erdleitung 102 mit einem Erdungspunkt 104 mit dem Erdpotential verbunden.

Das Erdschluss-Analysegerät 100 umfasst einen Strommesser 140 und eine Trenneinrichtung oder Trennbaustein 120. Der Trennbaustein 120, der nachfolgend im Zusammenhang mit Figur 3 näher erläutert wird, besitzt einen niederohmigen Zustand, der bei normal funktionierendem Stromnetz 200 aktiviert ist, und einen Trenn- beziehungsweise Unterbrechungszustand, bei welchem die elektrische Verbindung zwischen Netzanschluss 112 und Erdanschluss 114 im Erdschluss-Analysegerät 100 im Bereich des Trennbausteins 120 unterbrochen ist. Eine über die Trenneinrichtung 120 gemessene Spannung kann über einen Spannungskontakt 124 der Trenneinrichtung 120 an eine Steuerung 110 des Erdschluss-Analysegeräts 100 übermittelt werden. Weiterhin kann ein Signal zur Steuerung der Trenneinrichtung 120 von der Gerätesteuerung 110 über einen Steuerungseingang 122 der Trenneinrichtung 120 an die Trenneinrichtung 120 übermittelt werden.

Die Strommesseinrichtung 120, die im Rahmen von Figur 4 noch näher erläutert wird, weist einen Strommessausgang 142 auf, der mit der Steuereinrichtung 110 verbunden ist und mittels welchem sich ein gemessenes Strommesssignal an die Steuereinrichtung 110 übermitteln lässt.

Weiterhin ist in Figur 2 auch die bereits die in Figur 1 dargestellte Warnlampe 160, sowie die Normalzustandslampe 162 des Erdschluss-Analysegeräts 100 dargestellt, die beide ebenfalls mit der Gerätesteuerung 110 verbunden sind und von diesen beispielsweise in den in der vorliegenden Beschreibung dargstellten Fallkonstellationen angesteuert werden kann. Mit der Gerätesteuerung 110 ist ein Schnittstellen-Controller 112 für eine I/O-Link-Schnittstelle verbunden, der wiederum mit dem I/O-Link-Stecker 116 verbunden ist, der auch in Figur 1 schon dargestellt ist.

Von diesem Stecker 116 führt ein I/O-Link-fähiges Kabel zu einem I/O-Link-Mastermodul 310, welches wiederum mit einer speicherprogrammierbaren Steuerung (SPS) 320 verbunden ist. Die speicherprogrammierbaren Steuerung 320 und das I/O-Link-Modul 310 bilden ein Beispiel für ein Automatisierungssystem gemäß der vorliegenden Beschreibung.

Im Normalzustand des Erdschluss-Analysegeräts 100 befindet sich der Trennbaustein 200 im Verbindungs-Zustand und über eine Strommessung des Strommessbausteins 140 lässt sich ein Maß für den Kurzschlusswiderstand 232 bzw. den darüber abfließenden Strom ermitteln. Der Strommesswert wird dann über die Steuereinrichtung 110 und den Schnittstellen-Controller 112 an die SPS 320 übermittelt, um von dieser einem Benutzer dargestellt zu werden. Befindet sich dieser gemessene Stromwert in einem Normalbereich, so wird von der Steuereinrichtung 110 nur die Normal-Leuchte 162 betrieben. Übersteigt der Stromwert einen beispielsweise in der Steuereinrichtung 110 oder dem Erdschluss-Analysegerät 100 gespeicherten Grenzwert, so wird zusätzlich, oder auch alleine, die Warnleuchte 160 eingeschaltet und weiterhin über die I/O-Link-Schnittstelle 112 und die SPS 320 ein entsprechendes Warnsignal an einen Benutzer ausgegeben.

Die SPS 320 kann dabei so programmiert sein, dass bei Übersteigen eines weiteren Stromgrenzwerts von der SPS 320 ein Steuersignal über die I/O-Link-Schnittstelle 112, die Steuereinrichtung 110 und den Schalteranschluss 122 ein Signal an die Trenneinrichtung 120 zum Einstellen des Trennzustands der Trenneinrichtung 120 ausgegeben wird. Damit wird die bis dahin vorhandene Punkterdung des Stromkreises 200 aufgetrennt. Dies ermöglicht einen Notbetrieb des Stromnetzes 200, bei welchem der über die Erde abfließenden Kurzschlussstroms reduziert ist oder verschwindet. Weiterhin gibt die SPS 320 ein entsprechendes Warnsignal an einen Bediener, der sich dann um die Fehleranalyse des Stromnetzes 200 kümmern kann.

Figur 3 zeigt ein Beispiel für einen Aufbau des in Figur 2 dargestellten Trennbausteins 120. Dieser umfasst einen steuerbaren Schalter 123, der über den Schalteranschluss 122 ein Signal zum Öffnen oder Schließen erhalten kann und sich daraufhin entsprechend öffnet und schließt. Weiterhin umfasst der Trennbaustein einen Spannungsmesser 125, welcher die über dem Schalter 123 abfallende Spannung messen kann und über den Messausgang 124 an die Steuerung 110 der Erdschluss-Analyseeinrichtung 100 ausgibt.

Figur 4 zeigt ein Beispiel für das in Figur 2 dargestellte Strommessgerät 140. Dieses weist einen relativ niederohmigen, so genannten "Shunt"-Widerstand 144 aus, und ein Spannungsmessgerät 143 zur Messung der über den Shunt 144 abfallenden Spannung als Maß für den durch den Strommesser 140 fließenden Strom. Der Spannungsmesser 143 ist mit dem Stromwertausgabeausgang 142 verbunden, über den dann das entsprechende gemessene Strommesswertsignal an die Steuereinrichtung 110 des Erdschluss-Analysegeräts 100 ausgegeben werden kann.

## Patentansprüche

1. Analysesystem für ein Stromnetz, umfassend:
eine Automatisierungseinrichtung (310, 320), sowie eine Analysevorrichtung (100) zur Analyse eines Stromnetzes (200), insbesondere zur Erdschluss-Analyse eines Stromnetzes (200), die Analysevorrichtung (100) umfassend:
a. ein erstes Anschlusselement (112) zum Herstellen einer elektrischen Verbindung der Analysevorrichtung (100) mit einem Leitungselement eines Stromnetzes, insbesondere mit einem Anschlusspunkt des Stromnetzes (200) im Bereich einer Spannungsversorgung (210) für das Stromnetz (200),
b. ein zweites Anschlusselement (114) zum Herstellen einer elektrischen Verbindung der Analysevorrichtung (100) mit einem Erdpotential,
c. eine Strommesseinrichtung (140) zur Messung eines Stroms durch die Analysevorrichtung (100) zwischen erstem (112) und zweitem Anschlusselement (114), wobei die Analysevorrichtung (100) weiterhin eine Trenneinrichtung (120) umfasst, die derart eingerichtet und augebildet ist, dass
- in einem Verbindungszustand der Trenneinrichtung (120) eine durchgehende, insbesondere niederohmige, elektrische Verbindung zwischen dem ersten (112) und zweiten Anschlusselement (114) innerhalb der Analysevorrichtung (100) besteht, und
- in einem Trennzustand der Trenneinrichtung (120) eine Unterbrechung der durchgehenden elektrische Verbindung zwischen dem ersten (112) und zweiten Anschlusselement (114) innerhalb der Analysevorrichtung (100) vorliegt oder diese durchgehende elektrische Verbindung sehr hochohmig ist,**dadurch gekennzeichnet, dass**
d. die Analysevorrichtung eine Feldbus-Schnittstelle (112, 116) zur Eingabe eines Steuerbefehls in die Analysevorrichtung umfasst,
wobei die Feldbus-Schnittstelle (112, 116) und die Analysevorrichtung (100) derart ausgebildet und eingerichtet sind, dass durch einen durch einen Feldbus in der Feldbus-Schnittstelle (112, 116) eingehenden Steuerbefehl die Trenneinrichtung (120) vom Verbindungszustand in den Trennzustand bringbar ist und/oder umgekehrt,
wobei die Automatisierungseinrichtung (310, 320) über eine Feldbus-Leitung mit der Feldbus-Schnittstelle (112, 116) der Analysevorrichtung (100) verbunden ist und weiterhin die Automatisierungseinrichtung (310, 320) derart ausgestaltet und eingerichtet ist, dass die Trenneinrichtung (120) über die Feldbus-Schnittstelle (112, 116) selbsttätig vom Verbindungszustand in den Trennzustand gebracht wird, wenn ein in der Analyseeinrichtung (100) ermittelter Strommesswert einen festen, vorgegebenen oder vorgebbaren Grenzwert übersteigt.

2. Analysesystem nach Anspruch 1,
**dadurch gekennzeichnet,**
**dass** die Feldbus-Schnittstelle (112, 116) der Analysevorrichtung (100) für einen Feldbus mit vier oder weniger Anschluss-Leitungen, insbesondere für einen Feldbus gemäß dem "I/O-Link"-Standard oder dem "AS-i"-Standard, ausgebildet und eingerichtet ist.

3. Analysesystem nach Anspruch 1 oder 2,
**dadurch gekennzeichnet,**
**dass** die Feldbus-Schnittstelle (112, 116) der Analysevorrichtung (100) zur Ausgabe eines von der Strommesseinrichtung (140) ermittelten Messwerts über den Feldbus ausgebildet und eingerichtet ist.

4. Analysesystem nach einem der Ansprüche 1 bis 3,
**dadurch gekennzeichnet,**
**dass** die Analysevorrichtung (100) des Analysesystems (100) ein Bedienelement zum manuellen Umschalten der Trenneinrichtung (120) vom Verbindungszustand in den Trennzustand und/oder umgekehrt umfasst.

5. Analysesystem nach einem der Ansprüche 1 bis 4,
**dadurch gekennzeichnet,**
**dass** die Analysevorrichtung (100) weiterhin eine Spannungsmesseinrichtung (125) zur Messung und Ausgabe einer über die Trenneinrichtung (120) und/oder innerhalb der Trenneinrichtung (120) abfallenden Spannung umfasst, wobei insbesondere die Feldbus-Schnittstelle (112, 116) zur Ausgabe eines von der Spannungsmesseinrichtung (125) ermittelten Messwerts über den Feldbus eingerichtet ist.

6. Analysesystem nach einem der Ansprüche 1 bis 5,
**dadurch gekennzeichnet,**
**dass** die Automatisierungseinrichtung (310, 320) eine Bedieneinheit, insbesondere eine tragbare Bedieneinheit, zur Anzeige von in der Analysevorrichtung (100) ermittelten Strom- und/oder Spannungsmesswerten beziehungsweise Strom- und/oder Spannungsmesswert-Bereichen aufweist.

7. Analysesystem nach Anspruch 6,
**dadurch gekennzeichnet,**
**dass** die Bedieneinheit oder die tragbare Bedieneinheit zur Eingabe eines Steuerbefehls zum Umschalten der Trenneinrichtung (120) von dem Verbindungszustand in den Trennzustand und/oder umgekehrt ausgebildet und eingerichtet ist.

8. Analysesystem nach einem der Ansprüche 1 bis 7,
**dadurch gekennzeichnet,**
**dass** die Automatisierungseinrichtung (310, 320) derart ausgestaltet und eingerichtet ist, dass einem Bediener mindestens ein von der Analysevorrichtung (100) ermittelter Strommesswert angezeigt wird, wenn die Trenneinrichtung (120) im Verbindungszustand ist,
und/oder
**dass** die Automatisierungseinrichtung (310, 320) derart ausgestaltet und eingerichtet ist, dass einem Bediener mindestens ein von der Analysevorrichtung (100) ermittelter Spannungswert angezeigt wird, wenn die Trenneinrichtung (120) im Trennzustand ist.

## Claims

1. Analysis system for a power supply system, comprising:
an automation device (310, 320) and an analysis apparatus (100) for analysing a power supply system (200), in particular for analysing an earth fault of a power supply system (200), the analysis apparatus (100) comprising:
a. a first connection element (112) for establishing an electrical connection of the analysis apparatus (100) to a line element of a power supply system, in particular to a connection point of the power supply system (200) in the region of a voltage supply (210) for the power supply system (200),
b. a second connection element (114) for establishing an electrical connection of the analysis apparatus (100) to an earth potential,
c. a current measuring device (140) for measuring a current through the analysis apparatus (100) between the first (112) and second (114) connection elements,
the analysis apparatus (100) also comprising an isolating device (120) which is set up and designed in such a manner that
- a continuous, in particular low-impedance, electrical connection exists between the first (112) and second (114) connection elements inside the analysis apparatus (100) in a connection state of the isolating device (120), and
- there is an interruption in the continuous electrical connection between the first (112) and second (114) connection elements inside the analysis apparatus (100) or this continuous electrical connection has a very high impedance in an isolation state of the isolating device (120),
**characterized in that**
d. the analysis apparatus comprises a field bus interface (112, 116) for inputting a control command to the analysis apparatus,
the field bus interface (112, 116) and the analysis apparatus (100) being designed and set up in such a manner that the isolating device (120) can be changed from the connection state to the isolation state and/or vice versa by means of a control command which arrives in the field bus interface (112, 116) through a field bus,
the automation device (310, 320) being connected to the field bus interface (112, 116) of the analysis apparatus (100) via a field bus line, and the automation device (310, 320) also being configured and set up in such a manner that the isolating device (120) is automatically changed from the connection state to the isolation state via the field bus interface (112, 116) if a current measured value determined in the analysis device (100) exceeds a fixed, predefined or predefinable limit value.

2. Analysis system according to Claim 1,
**characterized**
**in that** the field bus interface (112, 116) of the analysis apparatus (100) is designed and set up for a field bus having four or less connection lines, in particular for a field bus according to the "I/O link" standard or the "AS-i" standard.

3. Analysis system according to Claim 1 or 2,
**characterized**
**in that** the field bus interface (112, 116) of the analysis apparatus (100) is designed and set up to output a measured value determined by the current measuring device (140) via the field bus.

4. Analysis system according to one of Claims 1 to 3,
**characterized**
**in that** the analysis apparatus (100) of the analysis system (100) comprises an operating element for manually changing over the isolating device (120) from the connection state to the isolation state and/or vice versa.

5. Analysis system according to one of Claims 1 to 4,
**characterized**
**in that** the analysis apparatus (100) also comprises a voltage measuring device (125) for measuring and outputting a voltage dropped across the isolating device (120) and/or dropped inside the isolating device (120), the field bus interface (112, 116), in particular, being set up to output a measured value determined by the voltage measuring device (125) via the field bus.

6. Analysis system according to one of Claims 1 to 5,
**characterized**
**in that** the automation device (310, 320) has an operating unit, in particular a portable operating unit, for displaying current and/or voltage measured values or current and/or voltage measured value ranges determined in the analysis apparatus (100).

7. Analysis system according to Claim 6,
**characterized**
**in that** the operating unit or the portable operating unit is designed and set up to input a control command for changing over the isolating device (120) from the connection state to the isolation state and/or vice versa.

8. Analysis system according to one of Claims 1 to 7,
**characterized**
**in that** the automation device (310, 320) is configured and set up in such a manner that at least one current measured value determined by the analysis apparatus (100) is displayed to an operator if the isolating device (120) is in the connection state,
and/or
**in that** the automation device (310, 320) is configured and set up in such a manner that at least one voltage value determined by the analysis apparatus (100) is displayed to an operator if the isolating device (120) is in the isolation state.

## Revendications

1. Système d'analyse pour un réseau électrique, comprenant :
un moyen d'automatisation (310, 320) et un dispositif d'analyse (100) destiné à l'analyse d'un réseau électrique (200), notamment à l'analyse de mise à la terre d'un réseau électrique (200), le dispositif d'analyse comprenant :
a. un premier élément de connexion (112) destiné à produire une liaison électrique du dispositif d'analyse (100) avec un élément conducteur du réseau électrique, notamment avec un point de raccordement du réseau électrique (200) dans la région d'une alimentation secteur (210) du réseau électrique (200),
b. un second élément de connexion (114) destiné à produire une liaison électrique du dispositif d'analyse (100) avec un potentiel de terre,
c. un moyen de mesure de courant (140) pour mesurer un courant à travers le dispositif d'analyse (100) entre le premier (112) et le second élément de connexion (114), dans lequel le dispositif d'analyse (100) comprend en outre un moyen de sectionnement (120), qui est agencé et conçu de telle sorte que
- dans un état connecté du moyen de sectionnement (120), une liaison électrique continue, notamment à faible valeur ohmique est produite entre le premier (112) et le second élément de connexion (114) à l'intérieur du dispositif d'analyse (100), et
- dans un état sectionné du moyen de sectionnement (120), une interruption de la liaison électrique continue est produite entre le premier (112) et le second élément de connexion (114) à l'intérieur du dispositif d'analyse (100) ou cette liaison électrique continue a une haute valeur ohmique,
**caractérisé en ce que**
d. le dispositif d'analyse comprend une interface de bus de terrain (112, 116) permettant d'entrer une instruction de commande dans le dispositif d'analyse,
dans lequel l'interface de bus de terrain (112, 116) et le dispositif d'analyse (100) sont conçus et agencés de telle sorte que, par une instruction de commande entrant dans l'interface de bus de terrain (112, 116) via un bus de terrain, le moyen de sectionnement (120) peut être amené de l'état connecté à l'état sectionné et/ou inversement, et
dans lequel le moyen d'automatisation (310, 320) est relié via une ligne de bus de terrain à l'interface de bus de terrain (112, 116) du dispositif d'analyse (100), et en outre,
le moyen d'automatisation (310, 320) est conçu et agencé de telle sorte que le moyen de sectionnement (120) est amené automatiquement, par l'intermédiaire de l'interface de bus de terrain (112, 116), de l'état connecté à l'état sectionné lorsqu'une valeur mesurée de courant déterminée dans le dispositif d'analyse (100) dépasse une valeur limite fixe, prescrite ou pouvant être définie.

2. Système d'analyse selon la revendication 1,
**caractérisé en ce que**
l'interface de bus de terrain (112, 116) du dispositif d'analyse (100) est conçue et agencée pour un bus de terrain comportant quatre liaisons de raccordement ou moins, notamment pour un bus de terrain conçu selon le standard « I/O link » ou le standard « AS-i ».

3. Système d'analyse selon la revendication 1 ou 2,
**caractérisé en ce que**
l'interface de bus de terrain (112, 116) du dispositif d'analyse (100) est conçue et agencée pour débiter une valeur de mesure déterminée par le moyen de mesure de courant (140) via le bus de terrain.

4. Système d'analyse selon l'une quelconque des revendications 1 à 3,
**caractérisé en ce que** le dispositif d'analyse (100) du système d'analyse (100) comprend un élément de commande permettant une commutation manuelle du moyen de sectionnement (120) de l'état connecté à l'état sectionné et/ou inversement.

5. Système d'analyse selon l'une quelconque des revendications 1 à 4,
**caractérisé en ce que** le dispositif d'analyse (100) comprend en outre un moyen de mesure de tension (125) destiné à mesurer et à débiter une tension appliquée à travers le moyen de sectionnement (120) et/ou à l'intérieur du moyen de sectionnement (120), dans lequel en particulier l'interface de bus de terrain (112, 116) est agencée pour débiter une valeur de mesure déterminée par le moyen de mesure de tension (125) via le bus de terrain.

6. Système d'analyse selon l'une quelconque des revendications 1 à 5,
**caractérisé en ce que**
le moyen d'automatisation (310, 320) comprend une unité de commande, notamment une unité de commande portable, permettant d'afficher des valeurs de mesure de courant et/ou de tension, ou des plages de mesure de courant et/ou de tension déterminées dans le dispositif d'analyse (100).

7. Système d'analyse selon la revendication 6,
**caractérisé en ce que**
l'unité de commande ou l'unité de commande portable est conçue et agencée pour entrer une instruction de commande pour commuter le moyen de sectionnement (120) de l'état connecté à l'état sectionné et/ou inversement.

8. Système d'analyse selon l'une quelconque des revendications 1 à 7,
**caractérisé en ce que** le moyen d'automatisation (310, 320) est conçu et agencé de telle sorte qu'au moins une valeur de mesure de courant déterminée par le dispositif d'analyse (100) est affichée à un opérateur lorsque le moyen de sectionnement (120) est à l'état connecté,
et/ou
**en ce que** le moyen d'automatisation (310, 320) est conçu et agencé de telle sorte qu'au moins une valeur de tension déterminée par le dispositif d'analyse (100) est affichée à un opérateur lorsque le moyen de sectionnement (120) est à l'état sectionné.
